# EUROPEAN PATENT SPECIFICATION

(11) **EP 4 528 591 B1**
(45) Date of publication and mention of the grant of the patent: **09.12.2026**
(21) Application number: 23198640.7
(22) Date of filing: 20.09.2023
(51) Int. Cl.: G06N 3/0455, G06N 3/0475, G06N 3/084, G06N 3/09, G01R 31/367

(54) **DEVICE AND METHOD OF CONSTRUCTING DIFFERENTIAL EQUATIONS**
VORRICHTUNG UND VERFAHREN ZUR KONSTRUKTION VON DIFFERENTIALGLEICHUNGEN
DISPOSITIF ET PROCÉDÉ DE CONSTRUCTION D'ÉQUATIONS DIFFÉRENTIELLES

(43) Date of publication of application: 26.03.2025
(73) Proprietor: Robert Bosch GmbH, 70442 Stuttgart (DE)
(72) Inventor: Avner, Orly, Haifa (IL); Linial, Ori, Haifa (IL); Di Castro, Dotan, 3440619 Haifa (IL)

(56) References cited:
- S\"OREN BECKER ET AL: "Predicting Ordinary Differential Equations with Transformers", ARXIV.ORG, CORNELL UNIVERSITY LIBRARY, 201 OLIN LIBRARY CORNELL UNIVERSITY ITHACA, NY 14853, 24 July 2023 (2023-07-24), XP091571913
- KIM EUGENE ET AL: "Modeling and Real-Time Scheduling of Large-Scale Batteries for Maximizing Performance", 2013 IEEE 34TH REAL-TIME SYSTEMS SYMPOSIUM, IEEE, 1 December 2015 (2015-12-01), pages 33 - 42, XP032850874, ISSN: 1052-8725, ISBN: 978-1-4673-9507-6, [retrieved on 20160114], DOI: 10.1109/RTSS.2015.11
- VASWANI VASWANI ASHISH ASHISH ET AL: "Attention Is All You Need", 12 June 2017 (2017-06-12), XP093045849, Retrieved from the Internet <URL:https://arxiv.org/pdf/1706.03762.pdf> [retrieved on 20230510], DOI: 10.48550/ARXIV.1706.03762

## Description

The invention concerns a method for finding a set of differential equations that can represent a multi-dimensional time series based on an architecture used for Large Language Models (LLMs) and a computer program and a machine-readable storage medium, and a system.

### Prior art

The authors of the publication https://arxiv.org/abs/2307.12617 developed a transformer-based sequence-to-sequence model that recovers scalar ordinary differential equations (ODEs) in symbolic form from irregularly sampled and noisy observations of a single solution trajectory.

From the publication https://arxiv.org/pdf/2106.06427 a symbolic regression method is known that leverages large scale pre-training. The authors procedurally generate an unbounded set of equations, and simultaneously pre-train a Transformer to predict the symbolic equation from a corresponding set of input-output-pairs.

The known methods from the state of the art are either limited to one dimensional Ordinary Differential Equations (ODEs) or can only deal with simple equations. One objective of the present invention is to overcome these limitations to succeed in modelling multi-dimensional time series data using differential equations.

### Advantages of the invention

The present invention introduces a modified LLM-style architecture, which enables to efficiently learn the mapping from multi-dimensional data to differential equations.

### Disclosure of the invention

The invention is defined by the independent claims.

Preferred embodiments of the invention are given by the dependent claims.

Embodiments of the invention will be discussed with reference to the following figures in more detail. The figures show:
- Figure 1: a high-level architecture for training;
- Figure 2: a high-level architecture for inference;
- Figure 3: a schematic signal embedding, a schematic signal encoder, a schematic equation embedding tokens;
- Figure 4: a schematic equation encoder;
- Figure 5: a schematic flow chart of an embodiment the invention.

### Description of the embodiments

The invention pertains to a machine learning system that is configured to iteratively construct a differential equation that describes an input time series. The machine learning system is made up of two main blocks: an encoder 11 and a decoder 12. The encoder translates the input signal from a time-series to an embedding, while the decoder has several functions: (1) encoding the equation (or, during inference, previously output equation term); (2) creating a shared embedding for the encoded signal and the encoded equation; (3) decoding the shared embedding and outputting the next equation term.

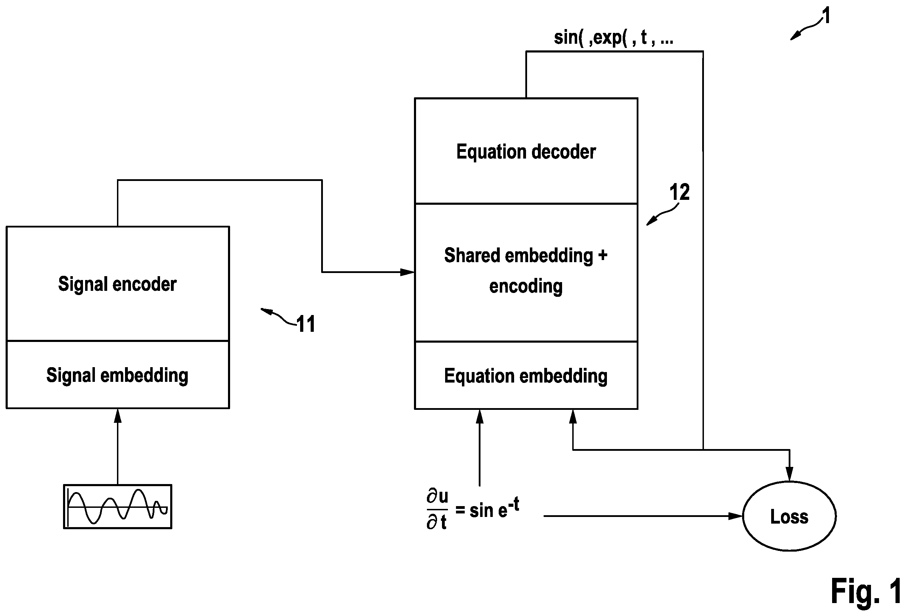

During the training process, a signal is inputted into the encoder and a matching equation, serving as the ground truth, is inputted into the decoder. Figure 1 presents the structure and data flow.

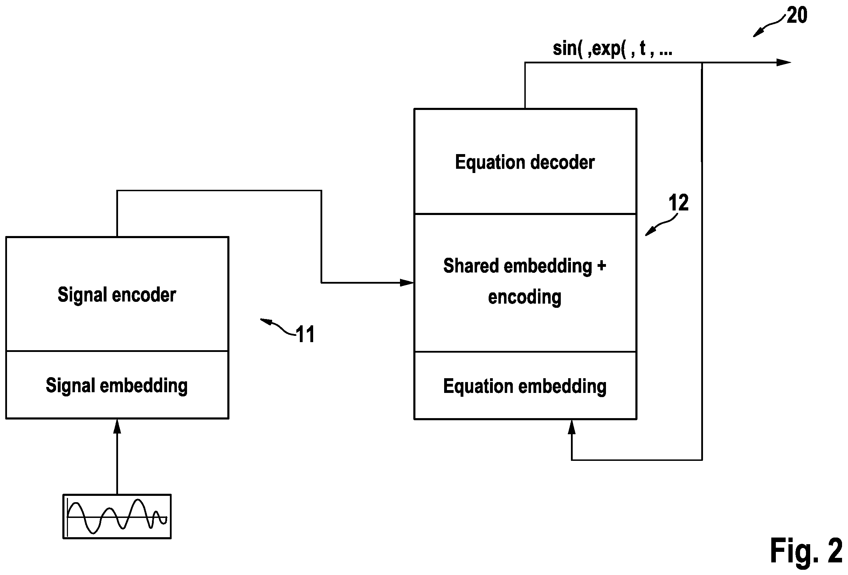

The flow for inference, in Figure 2, is similar, except for the absence of the ground truth and loss.

Before turning to a detailed description, we define the following notation. N represents a dimension of signal, for example, the signal in Figure 1 or 2 has N = *1. Tₙ* represents a length of *n*^{th} signal in timesteps. K represents a dimension of feature vector output by signal embedding. S represents a number of characters in an equation and *E*_{eq} represents a dimension of the equation embedding.

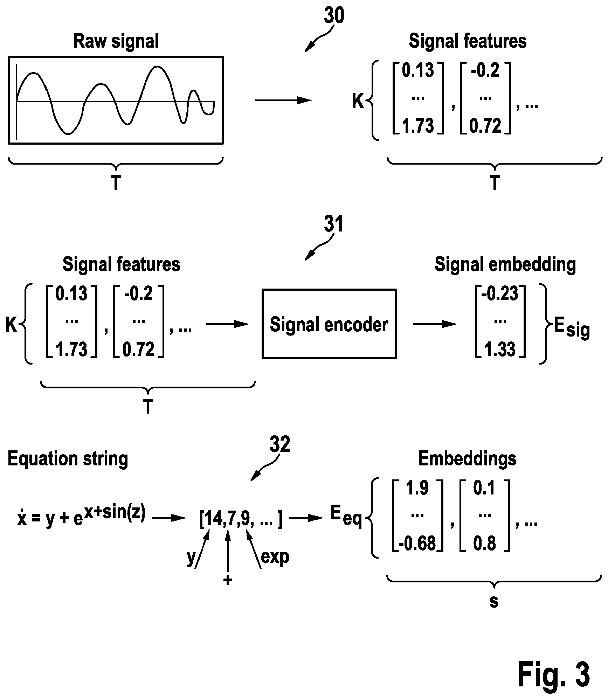

The encoder 11 is made up of two components:
1. A signal embedding that is obtained by applying a series of transformations, that takes *N* time series of length *Tₙ* and outputs a *K*-dimensional feature vector per time point. See Figure 3 reference sign 30 for illustration. Preferably, said transformation is carried out as follows: The first step is a conversion to floating point representation, then zero padding and finally a neural network is applied.
2. A signal encoder which is a transformer, followed by a pooling layer. The signal encoder encodes the signal embedding from a *T* × *K* tensor, to an *E*_{sig}-dimensional vector representing the signal. See Figure 3 reference sign 31 for illustration. It is noted that the choice of the *E*_{sig}-dimensional vector is only limited by hardware limitations (e.g., the size of the GPU) and thus chosen as hyperparameter and preferably adjusted according to a present hardware.

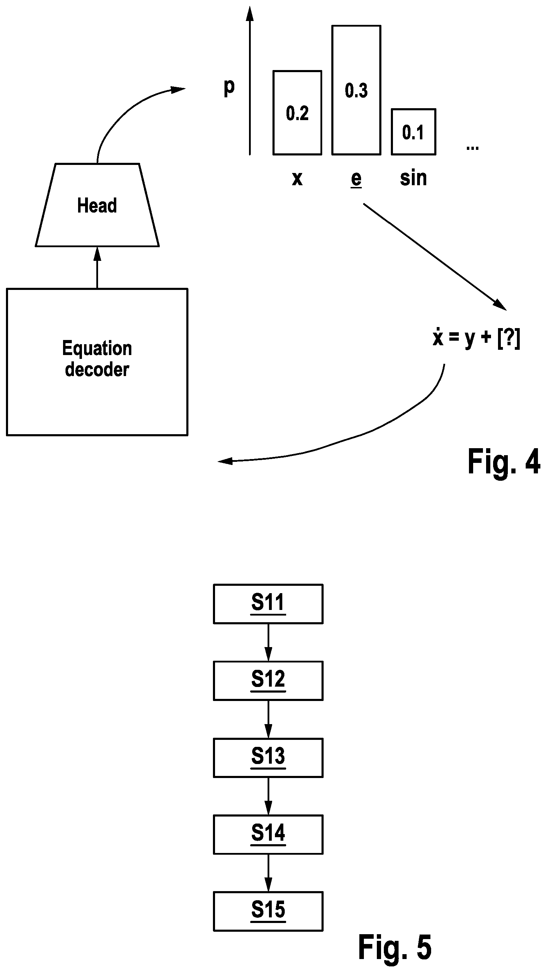

The decoder 12 comprises three components:
1. An equation embedding is which determined by tokenize an equation of *S* characters to unique integers, which are then transformed into an embedding of size *S* × *E*_{eq}. The tokenization can be a look up table, while the embedding is preferably determined by a (simple) neural network. See Figure 3 reference sign 32 for illustration.
2. A shared embedding plus encoding that concatenates the signal embedding with the equation embedding for each s = 1 ... *S.* The joint embedding is then fed into a fully connected network to prepare it for the decoder.
3. An equation decoder that can be a transformer, followed by a head that outputs the equation, symbol by symbol, see Figure 4.

Figure 5 shows a method for training and utilizing the trained machine learning systems for constructing differential equations that represents the input time series.

The method starts with step S11. In this step, the different models of the encoder 11 and decoder 12 are initialized.

This is followed by step S12. This step can be referred to as "training". Given a training data set comprising a plurality of time series and corresponding ground truth data, the initialized models are trained. The training can be carried out as a gradient based training, wherein parameters of the models are modified depending on gradients of loss functions. Preferably, the loss function is a cross entropy loss applied on the tokens of the equation strings. The loss function with respect to the parameters of the models can be optimized by a standard training approach: e.g. backpropagation of the loss through the entire system. It is noted that the training data set can be either a set of labeled time series by an expert, who assigned as labels differential equations, or the time series are simulated for predefined differential equations or a mix of both.

After the training is terminated, the trained encoder 11 and decoder 12 are utilized for constructing a differential equation for a given input time series. In step S14, the given input time series is propagated through the encoder 11 to obtain the signal encoding. This is followed by step S15, where the decoder 12 is iteratively applied. For the first iteration of the decoder 12, no equation embedding is present and thus the initial shared equation embedding plus signal encoding is just given by the signal encoding. This initial equation embedding plus signal encoding is propagated through the equation decoder, that outputs a first term of the differential equation. For the subsequent iterations of step S15, the shared equation embedding plus signal encoding is each time newly determined by concatenating the given signal encoding of step S14 with the updated equation embedding for the currently given terms of the differential equation. Step S15 is repeated until either a stop symbol is outputted by the head or by reaching a predefined max. length of symbols.

The decoder has a set of symbols for outputting, wherein the symbols comprise mathematical operations. The symbols can be simple mathematical functions (e.g. multiply, add, etc.) and/or sophisticated mathematical functions (e.g. sin, exp, etc.). In a preferred embodiment, the symbols also comprise brackets and/or a symbol indicating an exponent, wherein the exponent symbol indicates that the next outputted symbol is an exponent of the previously outputted symbol.

## Claims

1. A computer-implemented method of iteratively constructing a differential equation for an input time series measured on a technical system using a machine learning system (1) comprising an encoder (11) and a decoder (12), wherein the time series is a measured time series of an electrical energy storage, said method comprising:
Propagating (S14) the input time series through the encoder to obtain a signal encoding of said input time series;
Generating an initial shared equation embedding plus signal encoding from the signal encoding, wherein the initial shared equation embedding plus signal encoding equals the signal encoding; and
Iteratively applying (S15) the decoder on the shared equation embedding plus signal encoding to iteratively outputting individual terms of the differential equation and aggregate the individual terms to the differential equation, wherein after each outputted term by the decoder, the shared equation embedding plus signal encoding is updated by concatenating the signal encoding with an updated equation embedding for the current aggregated differential equation;
Outputting the aggregated differential equation; and
Determining depending on the outputted differential equation a de-/charging cycle or state of health for the energy storage.

2. The method according to claim 1, wherein the encoder comprises a signal embedding component and a signal encoder, wherein the signal embedding component transforms at least one time series into a feature vector for each time point of the time series, and the signal encoder encodes the signal embedding into a signal embedding vector representing the signal.

3. The method according to claim 1 or 2, wherein the decoder comprises an equation embedding component that tokenizes an equation of S characters into unique integers and transforms them into an equation embedding.

4. The method according to claim 3, wherein the decoder further comprises an equation decoder that utilizes a transformer followed by a head to output the equation symbol by symbol.

5. The method according to any of the preceding claims, wherein the machine learning system (1) has been trained by the following steps:
Initializing (S11) models and components of the encoder (11) and models of the decoder (12);
Training (S12) the initialized models using a training dataset comprising multiple time series and corresponding ground truth data comprising ODEs, wherein the training involves gradient-based parameter modification.

6. The method according to any of the preceding claims, wherein the time series is a measured time series of a battery, wherein the differential equation characterizes a behavior of the energy storage over time.

7. Computer program that is configured to cause a computer to carry out the method according to any one of claims 1 to 6 with all of its steps if the computer program is carried out by a processor.

8. Machine-readable storage medium on which the computer program according to claim 7 is stored.

9. Computer system that is configured to carry out the method according to any one of claims 1 to 6.

## Patentansprüche

1. Computerimplementiertes Verfahren zum iterativen Konstruieren einer Differentialgleichung für eine Eingabezeitreihe, die auf einem technischen System gemessen wird, unter Verwendung eines Maschinenlernsystems (1), das einen Codierer (11) und einen Decodierer (12) umfasst, wobei die Zeitreihe eine gemessene Zeitreihe eines elektrischen Energiespeichers ist, wobei das Verfahren Folgendes umfasst:
Propagieren (S14) der Eingangszeitreihe durch den Codierer, um eine Signalcodierung der Eingangszeitreihe zu erhalten;
Generieren einer initialen geteilten Gleichungseinbettung plus Signalcodierung aus der Signalcodierung, wobei die initiale geteilte Gleichungseinbettung plus Signalcodierung gleich der Signalcodierung ist; und
iteratives Anwenden (S15) des Decodierers auf die geteilte Gleichungseinbettung plus Signalcodierung, um iterativ individuelle Terme der Differentialgleichung auszugeben und die individuellen Terme zu der Differentialgleichung zu aggregieren, wobei nach jedem ausgegebenen Term durch den Decodierer die geteilte Gleichungseinbettung plus Signalcodierung durch Verketten der Signalcodierung mit einer aktualisierten Gleichungseinbettung der aktuellen aggregierten Differentialgleichung aktualisiert wird;
Ausgeben der aggregierten Differentialgleichung; und
Bestimmen eines Entlade-/Ladezyklus oder Gesundheitszustands für den Energiespeicher in Abhängigkeit von der ausgegebenen Differentialgleichung.

2. Verfahren nach Anspruch 1, wobei der Codierer eine Signaleinbettungskomponente und einen Signalcodierer umfasst, wobei die Signaleinbettungskomponente mindestens eine Zeitreihe in einen Merkmalsvektor für jeden Zeitpunkt der Zeitreihe transformiert und der Signalcodierer die Signaleinbettung in einen Signaleinbettungsvektor codiert, der das Signal repräsentiert.

3. Verfahren nach Anspruch 1 oder 2, wobei der Decodierer eine Gleichungseinbettungskomponente umfasst, die eine Gleichung von S Zeichen in eindeutige ganze Zahlen tokenisiert und sie in eine Gleichungseinbettung transformiert.

4. Verfahren nach Anspruch 3, wobei der Decodierer ferner einen Gleichungsdecodierer umfasst, der einen Transformator, gefolgt von einem Kopf, nutzt, um die Gleichung Symbol für Symbol auszugeben.

5. Verfahren nach einem der vorhergehenden Ansprüche, wobei das Maschinenlernsystem (1) durch die folgenden Schritte trainiert wurde:
Initialisieren (S11) von Modellen und Komponenten des Codierers (11) und Modellen des Decodierers (12);
Trainieren (S12) der initialisierten Modelle unter Verwendung eines Trainingsdatensatzes, der mehrere Zeitreihen und entsprechende Ground-Truth-Daten umfasst, die ODEs umfassen, wobei das Training gradientenbasierte Parametermodifikation beinhaltet.

6. Verfahren nach einem der vorhergehenden Ansprüche, wobei die Zeitreihe eine gemessene Zeitreihe einer Batterie ist, wobei die Differentialgleichung ein Verhalten der Energiespeicherung über die Zeit charakterisiert.

7. Computerprogramm, das konfiguriert ist, zu bewirken, dass ein Computer das Verfahren nach einem der Ansprüche 1 bis 6 mit allen seinen Schritten ausführt, falls das Computerprogramm durch einen Prozessor ausgeführt wird.

8. Maschinenlesbares Speicherungsmedium, auf dem das Computerprogramm nach Anspruch 7 gespeichert ist.

9. Computersystem, das dazu konfiguriert ist, das Verfahren nach einem der Ansprüche 1 bis 6 auszuführen.

## Revendications

1. Procédé mis en œuvre par ordinateur de construction itérative d'une équation différentielle pour une série temporelle d'entrée mesurée sur un système technique à l'aide d'un système d'apprentissage automatique (1) comprenant un codeur (11) et un décodeur (12), dans lequel la série temporelle est une série temporelle mesurée d'un stockage d'énergie électrique, ledit procédé comprenant :
la propagation (S14) de la série temporelle d'entrée à travers le codeur pour obtenir un codage de signal de ladite série temporelle d'entrée ;
la génération d'une intégration d'équation partagée initiale plus un codage de signal à partir du codage de signal, dans lequel l'intégration d'équation partagée initiale plus le codage de signal est égale au codage de signal ; et
l'application itérative (S15) du décodeur sur l'intégration d'équation partagée plus le codage de signal pour délivrer de manière itérative des termes individuels de l'équation différentielle et agréger les termes individuels dans l'équation différentielle, dans lequel après chaque terme délivré par le décodeur, l'intégration d'équation partagée plus le codage de signal est mise à jour en concaténant le codage de signal avec une intégration d'équation mise à jour pour l'équation différentielle agrégée actuelle ;
la délivrance de l'équation différentielle agrégée ; et
la détermination, en fonction de l'équation différentielle délivrée, d'un cycle de décharge/charge ou d'un état de santé pour le stockage d'énergie.

2. Procédé selon la revendication 1, dans lequel le codeur comprend un composant d'intégration de signal et un codeur de signal, le composant d'intégration de signal transformant au moins une série temporelle en un vecteur de caractéristiques pour chaque point temporel de la série temporelle, et le codeur de signal codant l'intégration de signal dans un vecteur d'intégration de signal représentant le signal.

3. Procédé selon la revendication 1 ou 2, dans lequel le décodeur comprend un composant d'intégration d'équation qui tokénise une équation de S caractères en entiers uniques et les transforme en une intégration d'équation.

4. Procédé selon la revendication 3, dans lequel le décodeur comprend en outre un décodeur d'équation qui utilise un transformateur suivi d'une tête pour délivrer l'équation symbole par symbole.

5. Procédé selon l'une quelconque des revendications précédentes, dans lequel le système d'apprentissage automatique (1) a été entraîné par les étapes suivantes :
l'initialisation (S11) de modèles et de composants du codeur (11) et de modèles du décodeur (12) ;
l'apprentissage (S12) des modèles initialisés à l'aide d'un ensemble de données d'apprentissage comprenant de multiples séries temporelles et des données de vérité de terrain correspondantes comprenant des ODE, l'apprentissage impliquant une modification de paramètre basée sur le gradient.

6. Procédé selon l'une quelconque des revendications précédentes, dans lequel la série temporelle est une série temporelle mesurée d'une batterie, l'équation différentielle caractérisant un comportement du stockage d'énergie dans le temps.

7. Programme informatique qui est configuré pour amener un ordinateur à réaliser le procédé selon l'une quelconque des revendications 1 à 6 avec toutes ses étapes si le programme informatique est exécuté par un processeur.

8. Support de stockage lisible par machine sur lequel est stocké le programme informatique selon la revendication 7.

9. Système informatique qui est configuré pour exécuter le procédé selon l'une quelconque des revendications 1 à 6.
